# FASCICULE DE BREVET EUROPEEN

(11) **EP 1 147 234 B1**
(45) Date de publication et mention de la délivrance du brevet: **01.09.2004**
(21) Numéro de dépôt: 00900585.1
(22) Date de dépôt: 14.01.2000
(51) Int. Cl.: C21D 7/02, H01F 41/02, H01F 27/245, B32B 15/08

(54) **PROCEDE DE TRAITEMENT D'UNE BANDE MINCE METALLIQUE FRAGILE ET PIECES MAGNETIQUES REALISEES A PARTIR D'UNE BANDE EN ALLIAGE NANOCRISTALLIN**
VERFAHREN ZUM BEHANDELN EINES DÜNNEN UND ZERBRECHLICHEN METALLBANDES UND AUS EINEM NANOKRISTALLINEN LEGIERUNGSBAND HERGESTELLTE MAGNETISCHE WERKSTÜCKE
METHOD FOR TREATING A BRITTLE THIN METAL STRIP AND MAGNETIC PARTS MADE FROM A NANOCRYSTALLINE ALLOY STRIP

(30) Priorité: 19.01.1999 FR 9900521
(43) Date de publication de la demande: 24.10.2001
(60) Demande divisionnaire: 03027268.6
(73) Titulaire: Imphy Alloys, 92800 Puteaux (FR)
(72) Inventeur: REYAL, Jean-Pierre, F-95610 Eragny (FR); SCHMIT, Francis, F-60250 Ansacq (FR)
(74) Mandataire: Bouget, Lucien
(86) Numéro de dépôt international: PCT/FR2000/000077
(87) Numéro de publication internationale: WO 2000/043556

(56) Documents cités:
- EP-A- 0 687 134
- EP-A- 0 695 812
- WO-A-91/12960
- DE-A- 3 503 019
- US-A- 3 189 483
- US-A- 4 096 815
- US-A- 4 558 297
- US-A- 4 749 625
- US-A- 5 198 040

## Description

L'invention concerne un procédé de traitement d'une bande mince métallique fragile et des produits obtenus à l'issue du traitement de la bande qui peut comporter des opérations de mise en forme telles qu'un découpage. En particulier, le procédé est relatif à l'obtention par découpage dans une bande métallique à structure nanocristalline, de pièces à usage magnétique.

On a proposé de fabriquer des bandes minces en alliage magnétique et en particulier en alliage à haute perméabilité, qui présentent une structure constituée principalement de grains très fins dans une matrice amorphe dont la taille peut être comprise par exemple entre 1 et 100 nm. De tels alliages sont appelés alliages nanocristallins.

Les matériaux métalliques nanocristallins sont obtenus, sous forme de bandes minces, par exemple d'une épaisseur de l'ordre de 20 µm, à partir de bandes ou rubans amorphes réalisés par coulée et refroidissement rapide d'un métal liquide sur un cylindre ou entre deux cylindres refroidis. Les bandes ou rubans amorphes sont traités thermiquement par maintien à une température de l'ordre de 550°C pendant une durée de l'ordre d'une heure, de manière qu'ils développent une structure nanocristalline, dans une partie substantielle, par exemple supérieure à 50 %, de leur volume.

Ce traitement thermique peut être précédé par des traitements thermiques préalables à des températures inférieures, par exemple de l'ordre de 200°C.

Lorsqu'on réalise la coulée, le refroidissement puis le traitement thermique d'alliages à base de fer magnétiquement doux, on peut obtenir, à partir de la bande à l'état nanocristallin, des produits tels que des noyaux de circuit magnétique, présentant d'excellentes propriétés magnétiques qui ne peuvent être obtenues généralement, dans le cas de matériaux dont la structure est différente d'une structure nanocristalline.

Cependant, un inconvénient des bandes ou rubans ayant une structure nanocristalline est que ces bandes ou rubans sont d'une très grande fragilité de telle sorte que la moindre sollicitation mécanique provoque une rupture de la bande ou ruban. Il n'est même pas possible de manipuler les bandes ou rubans de structure nanocristalline sans prendre de très grandes précautions, du fait que des contraintes, même très faibles, induites dans la bande conduisent à sa rupture fragile. Le seul procédé connu actuellement pour fabriquer des composants magnétiques tels que des noyaux magnétiques, à partir de bandes à structure nanocristalline, consiste à enrouler la bande d'alliage magnétique à l'état amorphe, puis de traiter thermiquement cette bande à la température à laquelle se développe la structure nanocristalline. Le traitement thermique peut être réalisé éventuellement sous champ magnétique pour modifier le cycle d'hystérésis de ces alliages nanocristallins.

Il n'est donc pas possible actuellement de fabriquer des composants magnétiques nanocristallins par des opérations de traitement mécanique ou d'usinage comportant, par exemple, un découpage.

L'obtention, à partir de bandes en alliage magnétique nanocristallin, de composants magnétiques ayant un contour dont la forme géométrique est bien définie présente un très grand intérêt. En particulier, il serait extrêmement intéressant de pouvoir fabriquer, à partir de bandes nanocristallines, des pièces magnétiques ayant la forme de rondelles, des formes en U ou en E ou encore des pièces ayant des formes complexes utilisées pour l'horlogerie.

De manière plus générale, il peut être extrêmement intéressant de disposer d'un procédé permettant le traitement d'une bande mince métallique fragile, d'une épaisseur faible, généralement inférieure à 0,1 mm, le traitement de la bande mettant en oeuvre au moins une étape dans laquelle la bande fragile est soumise à des contraintes, notamment de découpage ou de pliage.

Dans le EP-0.687.134, on a proposé de réaliser un transformateur miniaturisé comportant un noyau magnétique stratifié comportant une pluralité de bandes minces liées entre elles par des couches de résine. Le stratifié est coupé aux dimensions du noyau à obtenir.

Dans le US-4,558,247, on décrit un noyau saturable comportant une bande en alliage magnétique amorphe enroulée et un film isolant intercalé entre les spires successives du noyau.

Le but de l'invention est donc de proposer un procédé de traitement d'au moins une bande mince métallique fragile ayant une épaisseur inférieure à 0,1 mm, comportant au moins une étape dans laquelle la bande mince est soumise à des contraintes, ce procédé permettant d'éviter des risques de rupture de la bande fragile pendant son traitement et d'obtenir en particulier des pièces de forme géométrique précise et/ou complexe à partir de la bande mince fragile.

L'invention est definie dans les revendications 1, 17 et 23. Préalablement à l'étape du procédé dans laquelle la bande mince est soumise à des contraintes, on recouvre au moins une face de la bandé par une couche de revêtement comportant au moins un matériau polymère de manière à obtenir sur la bande une couche adhérente d'une épaisseur comprise entre 1 et 100 µm, modifiant les propriétés de déformation et de rupture de la bande mince métallique et on réalise l'étape du procédé dans laquelle la bande est soumise à des contraintes, sur la bande recouverte de la couche de revêtement.

Afin de bien faire comprendre l'invention, on va maintenant décrire, à titre d'exemple, en se référant aux figures jointes en annexe, la mise en oeuvre d'un procédé suivant l'invention, pour la réalisation par découpage de composants magnétiques, à partir d'une bande en un alliage magnétique nanocristallin.
La figure 1 est une vue schématique en élévation latérale d'une installation pour la mise en oeuvre du procédé suivant l'invention et suivant un premier mode de réalisation.
La figure 2 est une vue schématique en élévation latérale d'une installation pour la mise en oeuvre du procédé suivant l'invention et suivant un second mode de réalisation.
Les figures 3A, 3B et 3C sont des vues en perspective de pièces de transformateurs obtenues par un procédé selon l'invention comportant une étape de découpage d'une bande magnétique mince nanocristalline.
Les figures 4A, 4B et 4C sont des vues en perspective de noyaux magnétiques toriques obtenus par un procédé de traitement suivant l'invention comportant une étape de découpage.
La figure 5 est une vue en perspective d'un composant d'un circuit électrique obtenu par un procédé de traitement suivant l'invention de bandes minces nanocristallines.
Les figures 6A, 6B, et 6C sont des vues schématiques montrant trois phases successives de la mise en oeuvre d'un procédé de traitement suivant l'invention comportant une étape de découpage chimique.
La figure 7 est une vue de dessus montrant un ensemble de pièces obtenues par un procédé suivant l'invention mettant en oeuvre un découpage chimique.
Les figures 8A, 8B, 8C, 8D et 8E sont des vues schématique montrant les phases successives de la mise en oeuvre du procédé de l'invention pour la fabrication d'un transformateur intégré ou non intégré à un circuit imprimé.

Le procédé suivant l'invention tel qu'il sera décrit par la suite est utilisé pour la fabrication de pièces magnétiques planes en un matériau magnétique, sous forme nanocristalline.

Le matériau magnétique est un matériau magnétique doux, généralement constitué par un alliage renfermant principalement du fer ou, éventuellement, un mélange de fer et d'un métal ferromagnétique tel que le nickel et le cobalt, ainsi que du cuivre, du silicium, du bore et un métal tel que le niobium.

Le matériau magnétique pourrait également contenir du fer, du zirconium et du bore et éventuellement du cuivre et du silicium.

Les alliages magnétiques auxquels s'applique l'invention sont donc par exemple des alliages Fe-Cu-Nb-B-Si ou Fe-Zr-(Cu)-B-(Si) (les parenthèses autour des symboles Cu et Si indiquant que ces éléments peuvent être éventuellement absents).

L'invention peut bien sûr s'appliquer à d'autres alliages magnétiques.

A titre d'exemple, on a élaboré un alliage à base de fer présentant la composition atomique suivante :
Fe_{73,5} Cu₁ Nb₃ Si_{13,5} B₉.

Les nombres donnés en indice des éléments de l'alliage correspondent aux pourcentages atomiques de ces éléments dans l'alliage.

L'alliage de fer à l'état liquide est coulé sur un cylindre bon conducteur de la chaleur, efficacement refroidi, de manière à obtenir des bandes ou rubans à l'état amorphe d'une épaisseur de l'ordre de 20 µm et d'une largeur supérieure à 5 mm.

Les bandes ou rubans à l'état amorphe sont ensuite soumis à un traitement thermique de recuit à une température voisine de 550°C pendant une durée de l'ordre d'une heure, pour obtenir une structure à fins cristaux ou structure nanocristalline, dans une fraction volumique importante de la bande, par exemple une structure constituée, en volume, par au moins 50 % de grains d'une taille inférieure à 100 nm.

Le traitement selon l'invention est mis en oeuvre pour obtenir, par découpage de la bande, des pièces magnétiques de forme, en évitant une rupture de la bande métallique pendant le découpage. Le procédé de traitement suivant l'invention est généralement mis en oeuvre sur la bande à l'état nanocristallin. Dans certains cas, le traitement selon l'invention peut être mis en oeuvre sur une bande à l'état amorphe, un traitement thermique permettant ensuite de développer la structure nanocristalline.

La bande enroulée à l'état amorphe peut être introduite dans un four de traitement thermique, de telle sorte qu'on obtienne une bande nanocristalline enroulée sur un mandrin, à l'issue du traitement thermique. Ce traitement thermique peut être réalisé sous champ magnétique.

Le traitement suivant l'invention consiste dans un premier temps à recouvrir une face de la bande en alliage nanocristallin, d'une couche de revêtement comportant un polymère. La bande recouverte sur une de ses faces par une couche de matériau renfermant un polymère peut être manipulée sans risque de rupture. La bande peut alors être recouverte sur sa seconde face par une couche de matériau renfermant un polymère et les deux couches recouvrant la bande sont rendues adhérentes sur les faces de la bande, par application d'une pression et/ou par un traitement thermique.

Il est ensuite possible de superposer et d'assembler, par exemple par collage, pression ou traitement thermique, plusieurs bandes métalliques recouvertes sur une ou deux faces par une couche renfermant un polymère, de manière à obtenir des produits composites stratifiés comportant plusieurs couches métalliques superposées séparées par des couches renfermant une matière polymère.

Le traitement selon l'invention comporte une opération supplémentaire, par exemple d'usinage ou de formage de la bande métallique revêtue sur ses deux faces ou de la bande composite stratifiée, pour obtenir des pièces de forme, par exemple par découpage de la bande.

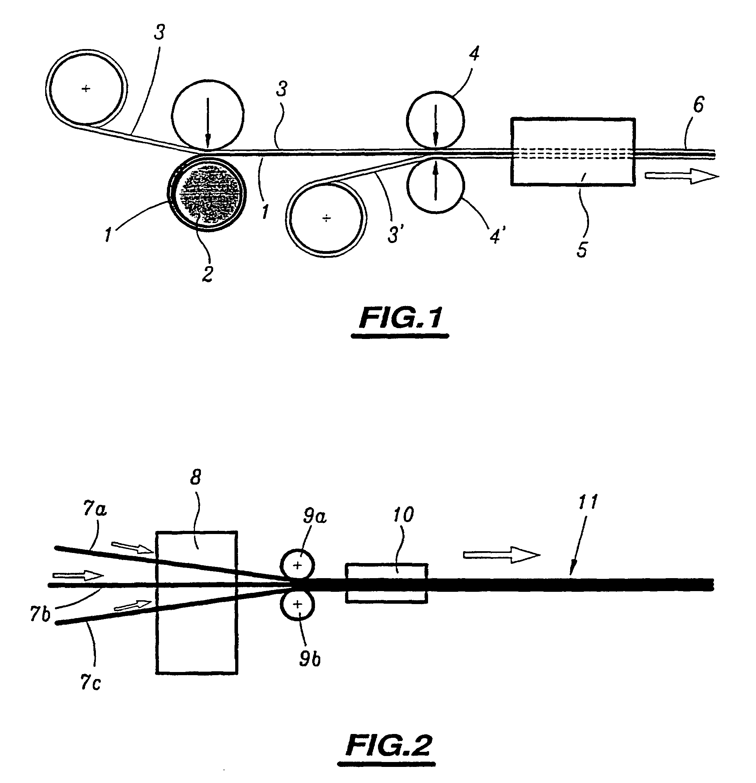

Comme il est visible sur la figure 1, dans un premier mode de réalisation du procédé de traitement suivant l'invention, on réalise le recouvrement d'une bande nanocristalline 1 sur une première et sur une seconde face successivement par un matériau adhésif constitué par un film plastique pré-encollé.

La bande d'alliage nanocristallin 1 est enroulée sur un mandrin 2 présentant un rayon de courbure suffisant pour éviter une déformation ou une mise en contrainte excessive de la bande 1. L'enroulement sur le mandrin 2 a été effectué sur la bande coulée et refroidie à l'état amorphe qui a ensuite été traitée thermiquement à 550°C environ à l'état enroulé sur le mandrin.

On réalise, dans un premier temps, le collage sur une première face de la bande 1 déroulée du mandrin 2 d'une bande en matériau polymère 3 pré-encollée. La bande 3 de matériau polymère pré-encollée est déroulée d'une bobine, puis appliquée et pressée contre la bande 1 d'alliage nanocristallin par un rouleau de pressage dans une disposition en vis-à-vis de la bobine constituée par la bande en alliage nanocristallin 1 enroulée sur le mandrin 2. De cette manière, on réalise la mise en contact et l'adhésion de la bande 3 sur la face supérieure de la bande en alliage nanocristallin 1, au point exact où la bande 1 est déroulée. On évite ainsi toute manipulation d'un tronçon de bande 1 non recouvert d'une couche de matière plastique pré-encollée.

La bande en alliage nanocristallin 1 recouverte sur sa face supérieure par la bande en matériau polymère 3 est mise en contact, sur sa face inférieure, avec une seconde bande en matériau polymère pré-encollée 3' enroulée sous la forme d'une bobine. Deux rouleaux pressage 4 et 4' en vis-à-vis permettent d'exercer une pression sur la bande 1 recouverte par les bandes 3 et 3' en matériau polymère. La pression exercée par les rouleaux de pressage 4 et 4' permet d'obtenir une bonne adhérence des bandes 3 et 3' sur les faces de la bande en alliage nanocristallin 1.

Il est possible, de manière à améliorer encore l'adhérence des bandes 3 et 3' sur les faces de la bande en alliage nanocristallin 1, de faire passer la bande stratifiée constituée par la bande 1 recouverte par les couches 3 et 3', dans une installation de traitement thermique 5 à l'intérieur de laquelle le matériau adhésif des bandes 3 et 3' est réticulé, ce qui améliore la qualité du collage.

A la sortie de l'installation de traitement thermique 5, la bande 1, solidarisée aux couches de recouvrement 3 et 3', constitue une bande stratifiée 6 dont le comportement à la déformation et à la rupture est fondamentalement différent du comportement de la bande en alliage nanocristallin 1 qui est essentiellement fragile. La bande stratifiée 6 ne présente plus un comportement fragile et ses modes de rupture sont radicalement différents des modes de rupture fragile de la bande 1. De ce fait, la bande 6 obtenue à l'issue de la première phase du procédé de traitement suivant l'invention peut être soumise à un cisaillement tel que celui mis en oeuvre dans un procédé de découpage mécanique de la bande. On peut ainsi obtenir par découpage de la bande 6 des pièces de forme sans risque de rupture de la bande 1 en alliage nanocristallin qui est fixée par ses deux faces aux bandes de recouvrement en matériau polymère 3 et 3'.

Pour obtenir des pièces magnétiques ayant des propriétés satisfaisantes, il est nécessaire que les bandes à structure nanocristallines présentent de faibles contraintes internes, ces contraintes étant à un niveau aussi faible que possible. Ce résultat peut être obtenu en effectuant le traitement thermique de bandes amorphes sur un mandrin ou un noyau ayant un grand rayon de courbure, comme décrit plus haut, ou en utilisant un four de traitement thermique de la bande non enroulée et dans un état non contraint, par exemple dans un four permettant le traitement de la bande posée à plat sur un support. Les opérations effectuées sur la bande nanocristalline recouverte de deux couches adhérentes de polymère ne créent pratiquement pas de contraintes dans la bande nanocristalline, même si ces opérations se traduisent par des contraintes externes, telles que des contraintes de cisaillement, importantes.

Les films en matière polymère 3 et 3' pré-encollés, qui sont utilisés pour recouvrir les deux faces de la bande 1, peuvent être constitués par un film en un matériau polymère tel qu'un polyester, un polytétrafluoro-éthylène (PTFE) ou un polyimide, le film étant associé à une couche de matériau auto-adhésif permettant l'encollage du film sur la bande. Certains matériaux auto-adhésifs peuvent être réticulés à l'intérieur d'une installation de traitement thermique telle que l'installation 5 représentée sur la figure 1.

Il est possible de fabriquer ensuite, à partir de bandes stratifiées 6 comportant une bande nanocristalline recouverte sur ses deux faces par des bandes en matériau polymère, un matériau composite stratifié comportant plusieurs bandes stratifiées 6 superposées et rendues adhérentes les unes aux autres, par pression et/ou par traitement thermique. On peut obtenir en particulier de tels composites à partir de bandes stratifiées 6 constituées de la bande nanocristalline 1 recouvertes sur ses deux faces ou sur une seule face par des bandes polymère double face, c'est-à-dire des bandes ayant des couches auto-adhésives sur leurs deux faces.

Du fait que les bandes stratifiées ou composites obtenues ne présentent plus de risque de rupture fragile pendant le découpage de pièces, on peut réaliser, à partir de ces bandes stratifiées ou composites, toute pièce magnétique par exemple en forme d'U ou en forme d'E, ou encore toute pièce magnétique de forme complexe utilisée en horlogerie, comme il sera expliqué plus loin.

Les couches en matériau polymère utilisées pour recouvrir la bande nanocristalline sont choisies de manière qu'on évite de dégrader les caractéristiques magnétiques des bandes nanocristallines par les contraintes induites lors de l'adhésion de la bande en polymère sur la bande nanocristalline ou lors de l'opération de réticulation des polymères en contact avec la bande nanocristalline. On évitera généralement de mettre la bande sous forte contrainte de tension ou de compression pendant la phase d'adhésion ou de réticulation.

Dans certains cas, on peut cependant ajuster les caractéristiques magnétiques du stratifié ou matériau composite comportant une ou plusieurs bandes nanocristallines, en utilisant les caractéristiques de magnétostriction de la ou des bandes nanocristallines et en exerçant certaines contraintes sur les bandes nanocristallines, par l'intermédiaire des couches à base de polymère.

Dans certaines applications, par exemple dans le cas de composants destinés à la fabrication de systèmes de conversion d'énergie, les composants magnétiques obtenus par le procédé de l'invention doivent pouvoir résister à une température relativement élevée, par exemple à une température de 150°C. Dans ce cas, bien entendu, les polymères constituant les couches de recouvrement de la bande nanocristalline, qui restent fixés sur les pièces magnétiques obtenues après découpage, doivent supporter la température d'utilisation des pièces magnétiques.

Au lieu de bandes de recouvrement en matériau polymère préencollées auto-adhésives, on peut utiliser comme couche de recouvrement des bandes nanocristallines un film polymère thermofusible qui ne devient adhésif que lors d'un traitement thermique. Un tel film thermofusible est dit «non tacky», du fait que sa partie thermofusible n'est pas adhésive à la température ambiante.

Sur la figure 2, on a représenté une phase d'un traitement suivant l'invention, au cours de laquelle on élabore un composite découpable constitué par des bandes nanocristallines et des couches de recouvrement en matière polymère liées entre elles par une matière thermofusible à l'issue d'un traitement thermique.

On utilise, comme précédemment, des bandes en alliage nanocristallin qui sont généralement enroulées sous forme de bobines et qui sont obtenues par traitement d'une bobine d'alliage à l'état amorphe. Chacune des bandes d'alliage nanocristallin utilisées pour la fabrication du composite est recouverte, sur sa face supérieure et sur sa face inférieure, par un film polymère thermofusible pré-encollé. On réalise ainsi une pluralité, par exemple trois, de bandes stratifiées 7a, 7b, 7c comprenant chacune une bande en alliage nanocristallin disposée entre deux films polymères. Les bandes 7a, 7b et 7c sont amenées à défiler à l'intérieur d'une enceinte de chauffage 8 à une température inférieure à 400°C qui permet de porter la température des films thermofusibles des couches de recouvrement des bandes stratifiées 7a, 7b, 7c au-dessus de la température de fusion du film thermofusible et de collage par contact. Le collage des bandes 7a, 7b et 7c est réalisé entre deux rouleaux de pressage 9a et 9b. Après refroidissement dans une enceinte de refroidissement 10, on obtient une bande composite 11 qui peut être découpée sous la forme de pièces magnétiques de forme.

Les films thermofusibles permettant l'adhésion des couches de recouvrement peuvent être constitués par l'un des polymères suivants : polyéthylène modifié (par l'acide acrylique, l'anhydride maléique ou autres), polypropylène greffé, polyamide, polyuréthanne.

Les propriétés du composite stratifié 11 obtenu par le procédé mis en oeuvre selon le second mode de réalisation permettent le découpage sans rupture et sans formation de contraintes indésirables dans les bandes en matériau nanocristallin.

Dans tous les cas envisagés ci-dessus, on obtient une bande stratifiée ou composite comportant une ou plusieurs bandes nanocristallines, chaque bande nanocristalline étant recouverte sur une ou sur ses deux faces d'une couche de polymère. De ce fait, il est possible de découper des pièces magnétiques dans les bandes stratifiées ou composites sans risque de rupture des bandes nanocristallines.

Dans le cas où l'on désire fabriquer des composants magnétiques du type torique à cycle couché, c'est-à-dire dont le rapport Bᵣ/Bₛ est très inférieur à 1, le découpage des pièces sera réalisé de manière à créer des interfaces de rupture dans les pièces composites découpées. Ces interfaces de rupture peuvent être réalisés par frappe, au moment du découpage.

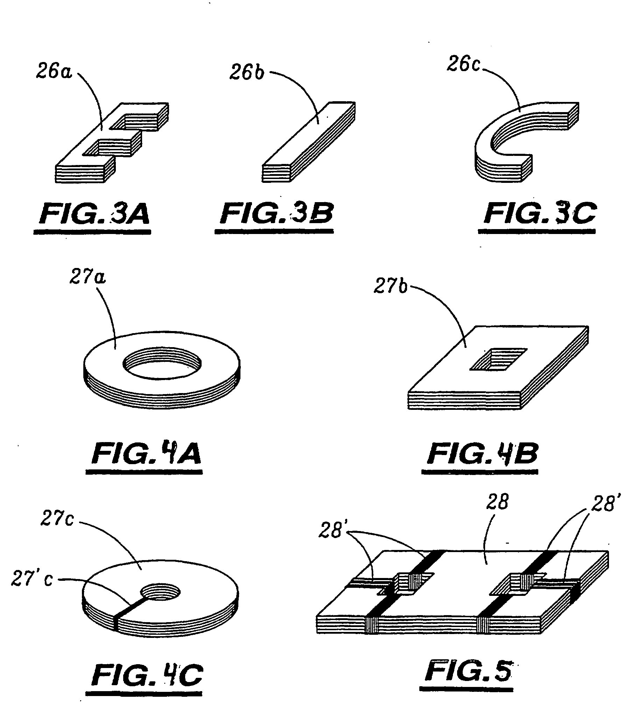

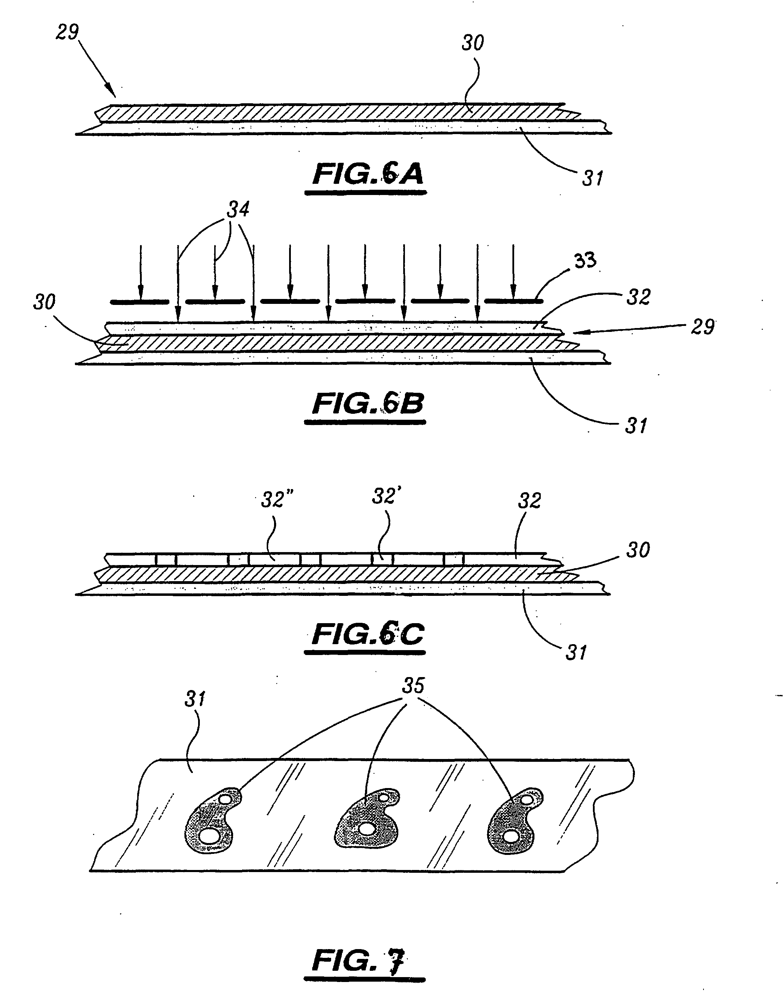

Sur les figures 3A, 3B et 3C, on a représenté des exemples de pièces réalisées par découpage de bandes en matériau composite stratifié constituées par superposition et solidarisation de bande stratifiées constituées chacune d'une bande nanocristalline recouverte d'une ou de deux couches de matériau polymère adhérentes sur les faces de la bande nanocristalline. Le matériau composite stratifié peut être constitué par une pluralité de bandes stratifiées superposées et liées entre elles, ce nombre de bandes superposées pouvant être par exemple égal à trois ou supérieur.

Par exemple, dans le cas de bandes nanocristallines d'une épaisseur de 20 µm recouvertes sur leurs deux faces par des couches en matériau polymère d'une épaisseur de 5 µm, un empilement de trois bandes stratifiées superposées présente une épaisseur de 80 µm, soit 0,08 mm.

On peut bien sûr réaliser des pièces magnétiques par découpage de bandes composites stratifiées plus épaisses, par exemple d'une épaisseur d'1 mm ou plus.

Dans un tel matériau composite stratifié, il est possible de réaliser des pièces de transformateurs en forme de E, de I ou de U, comme il est visible respectivement sur les figures 3A, 3B et 3C montrant respectivement une pièce de transformateur 26a en forme de E, une pièce de transformateur 26b en forme de I et une pièce 26c en forme de U.

De telles pièces de transformateurs présentent de très bonnes propriétés magnétiques, du fait qu'elles sont constituées par des couches d'alliage nanocristallin et de très bonne propriétés mécaniques, du fait que les feuilles d'alliage nanocristallin sont protégées par des couches en matière plastique adhérentes sur toute leur surface. En outre, comme indiqué plus haut, pendant le découpage des produits composites stratifiés, le risque de rupture des bandes nanocristallines est extrêmement réduit.

Le découpage de pièces telles que représentées sur les figures 6A, 6B et 6C peut être réalisé par tout procédé de découpage mécanique de pièces de forme, par exemple par frappe à l'emporte-pièce.

La structure stratifiée des pièces obtenues est également favorable pour limiter les pertes par courants de Foucault dans ces pièces, lorsqu'elles sont utilisées comme pièces de transformateurs.

Il est également possible d'utiliser des pièces découpées dans des matériaux composites stratifiés, selon le procédé de l'invention, qui puissent être utilisées comme noyaux toriques.

Comme il est visible sur les figures 4A et 4B, on peut réaliser des tores ayant la forme de rondelles découpées 27a, comme représenté sur la figure 4A, ou la forme de cadres à section carrée ou rectangulaire 27b, évidés en leur centre, comme représenté sur la figure 4B.

On peut également, comme représenté sur la figure 4C, réaliser des tores avec entrefer ayant la forme de rondelles stratifiées 27c comportant une fente radiale 27'c constituant un entrefer. Aussi bien le découpage des rondelles 27c que la réalisation de la fente 27'c peuvent être réalisés sans risque de rupture des bandes nanocristallines constituant le produit composite stratifié. On obtient ainsi des tores coupés qui peuvent être de très petites dimensions.

De manière générale, les pièces obtenues telles que représentées sur les figures 3A à 3C et 4A à 4C peuvent être des pièces de petites ou de très petites dimensions qui présentent également une forme plate et une très faible épaisseur.

Il est possible également, de réaliser par le procédé de l'invention, des pièces pour circuits magnétiques minaturisés, par exemple pour réaliser des rotors ou stators de montres.

Il est également possible de réaliser des pièces pour rotors ou stators de moteurs, en particulier de moteurs électriques de très petites dimensions.

Le procédé suivant l'invention peut être également utilisé pour réaliser des étiquettes antivol en matériau à haute perméabilité dont la présence sur un article ou objet peut être repérée lors du passage de l'objet dans une boucle d'un circuit parcourue par un courant. Le passage de l'objet portant l'étiquette antivol est alors détecté par la variation du courant induit dans la boucle.

Comme il est visible sur la figure 5, on peut également réaliser par le procédé suivant l'invention des inductances ou transformateurs minces 28, ayant une épaisseur qui peut être par exemple de l'ordre d'un millimètre, permettant le montage de ces inductances ou transformateurs minces, contre une surface d'un dispositif.

Une bande composite stratifiée comportant des couches stratifiées superposées constituées chacune d'une bande nanocristalline entourée par des couches de matière polymère sont découpées, par exemple sous la forme de rectangles 28 dans lesquels sont ménagées des ouvertures par exemple à section carrée. A partir de la pièce obtenue, on peut réaliser par bobinage de fils électriques 28' les parties primaire et secondaire d'un transformateur.

Dans tous les exemples de mise en oeuvre de l'invention décrits jusqu'ici, on réalise le découpage des pièces magnétiques dans les bandes stratifiées ou composites stratifiées par un procédé mécanique.

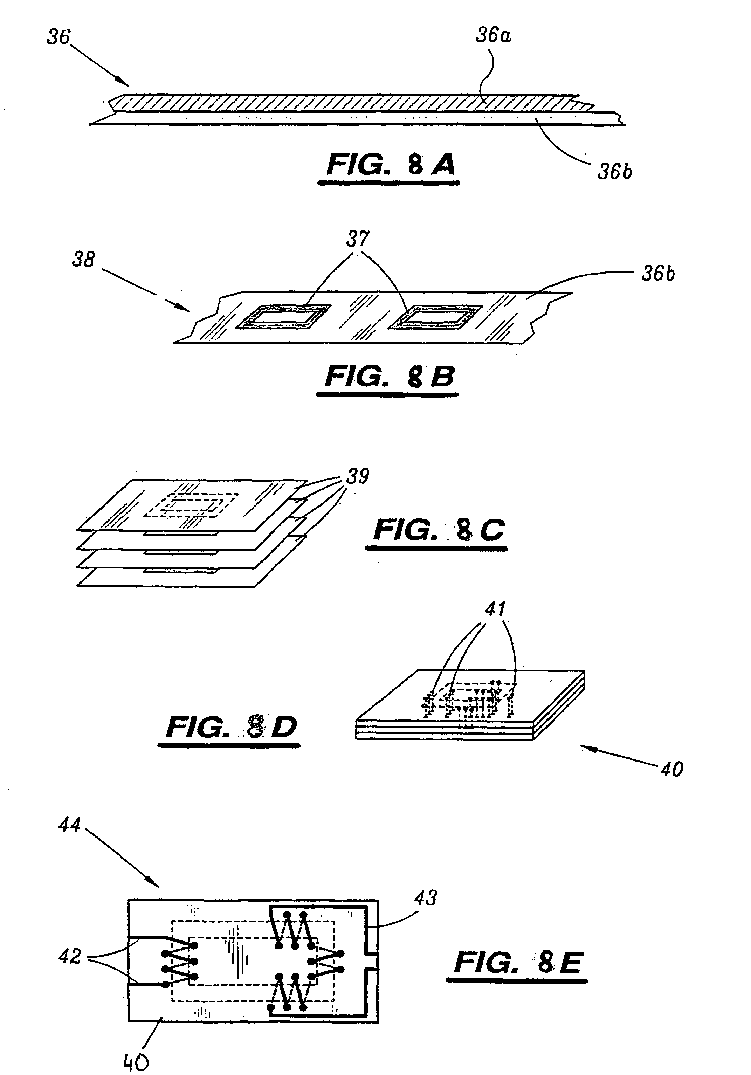

Comme représenté sur les figures 6A à 6C et 7, il est également possible de réaliser des pièces magnétiques de forme complexe à partir de bandes minces en alliage nanocristallin, par un procédé de découpage chimique.

Comme représenté sur la figure 6A, on réalise, dans un premier temps un stratifié 29, à partir d'une bande en alliage nanocristallin 30 qui est revêtue sur l'une de ses faces par une bande de matière polymère 31 dont on assure la liaison avec la bande 30 par un procédé tel que décrit plus haut.

Comme représenté sur la figure 6B, on recouvre ensuite la bande stratifiée 29 par une couche 32 d'une résine photosensible et on réalise, à travers un écran 33 de forme adaptée, l'insolation par des rayons de lumière 34 de la couche en résine photosensible 32 déposée sur la surface externe de la bande en alliage nanocristallin du stratifié 29.

Comme il est visible sur la figure 6C, on supprime ensuite de la couche de résine photosensible 32, partiellement insolée, soit les parties insolées 32' soit les parties cachées par l'écran 33 et non insolées 32", à l'aide d'un solvant approprié. Par exemple, le solvant utilisé peut être de l'eau dans le cas où la couche photosensible est constituée par de la caséine modifiée.

On réalise par une technique analogue au gravage, en utilisant une substance d'attaque telle qu'un acide, ou du chlorure ferrique, le découpage de pièces suivant les parties non revêtues de la couche 32.

On obtient, comme représenté sur la figure 7, des pièces magnétiques 35 collées sur la bande support 31 en matériau polymère du matériau stratifé 29. On obtient ainsi sans risque de rupture des pièces qui sont elles-mêmes protégées et conditionnées à la sortie de la ligne de fabrication.

A partir de pièces ainsi obtenues, on peut, comme représenté sur les figures 8A à 8E, réaliser la fabrication d'un transformateur intégré à un circuit imprimé ou un transformateur discret, par un procédé selon l'invention.

Dans une première étape, on élabore un stratifié 36 (figure 8A) constitué d'une bande en alliage nanocristallin 36a et d'un film de matière polymère 36b adhérent sur une des faces de la bande 36a. On réalise, par exemple par le procédé décrit plus haut en regard des figures 6A, 6B, 6C et 7, un produit 38 comportant le film de matière plastique 36b comme substrat et des circuits magnétiques successifs minces 37 en alliage nanocristallin, par exemple en forme de cadres rectangulaires, adhérant sur le substrat (figure 8B).

On découpe le produit 38 en tronçons comportant chacun un circuit magnétique mince 37 fixé sur un tronçon de substrat. On empile les tronçons découpés (39 (figure 8C), l'un sur l'autre de manière que les circuits magnétiques 37 soient exactement superposés et séparés par les couches de substrat en matière plastique 36b. On réalise l'adhésion l'une sur l'autre des couches superposées 36b, par exemple par chauffage et pressage, pour obtenir un produit stratifié composite 40 (figure 8D). On réalise, comme représenté sur la figure 8D, le perçage des films de matière plastique superposés 36b, dans des zones situées à l'intérieur et à l'extérieur des circuits magnétiques 37 superposés, pour obtenir une pluralité d'ouvertures 41 traversant le stratifié composite 40. Les ouvertures 41 sont ensuite métallisées intérieurement, de manière à créer des zones conductrices continues entre les deux faces du stratifié composite 40 sur lesquelles débouchent les ouvertures 41.

On réalise ensuite (figure 8E), sur les deux faces du stratifié composite 40, par exemple par gravure chimique, des conducteurs électriques tels que 42 et 43 joignant les extrémités d'un premier ensemble d'ouvertures 41 sur chacune des faces du stratifié composite 40 et d'un second ensemble d'ouvertures 41, respectivement.

Les conducteurs 42 et 43 et les ouvertures métallisées 41 auxquelles ils sont reliés constituent les enroulements primaire et secondaire du transformateur 44 qui peut être utilisé dans un circuit imprimé.

Par ce procédé, on pourrait également réaliser d'autres composants tels que des inductances destinés à être insérés dans un circuit imprimé ou intercalés sur un circuit imprimé et comportant au moins un enroulement.

Le procédé suivant l'invention permet d'obtenir des pièces magnétiques de formes complexes en alliage nanocristallin, ce qui n'était pas possible jusqu'ici, les seules pièces en alliage nanocristallin pouvant être obtenues étant des noyaux toriques constitués par une bande enroulée.

On peut également obtenir des bandes en alliage nanocristallin qui ne sont pas fragiles par recouvrement d'une face d'un ruban en alliage nanocristallin par un revêtement ou un film renfermant au moins une matière plastique.

Dans le cadre d'un traitement suivant l'invention, ces bandes peuvent être manipulées et mises en oeuvre de manières diverses et par exemple refendues sous la forme de bandes ayant une largeur inférieure à la largeur de la bande nanocristalline coulée sous forme amorphe et traitée thermiquement.

Le procédé suivant l'invention permet d'éviter les risques de rupture des bandes minces en alliage nanocristallin pendant le formage des pièces magnétiques, par exemple par découpage ou perçage.

L'invention ne se limite pas non plus aux modes de réalisation qui ont été décrits plus haut.

C'est ainsi qu'on peut réaliser le recouvrement de la bande métallique mince fragile par une couche de revêtement renfermant un matériau polymère, d'une manière différente de celles qui ont été décrites plus haut.

L'invention ne se limite pas non plus à la nature et à la composition des couches réalisées sur les bandes métalliques minces, pendant la première phase du procédé suivant l'invention.

L'invention ne se limite pas non plus au cas où l'on réalise un découpage des bandes dans une seconde étape du procédé mais s'applique à tous les cas où l'on réalise une manipulation ou un usinage sur des bandes métalliques minces fragiles, cette manipulation ou usinage entraînant une mise sous contrainte de la bande fragile.

L'invention peut s'appliquer dans des domaines différents de la fabrication de pièces magnétiques.

## Revendications

1. Procédé de traitement d'une bande mince métallique fragile (1, 30) en alliage magnétique doux à structure nanocristalline renfermant au moins 50 % en volume de fins cristaux d'une taille inférieure à 100 µm obtenue par coulée du matériau magnétique doux sous forme d'une bande amorphe et traitement thermique de la bande amorphe, ayant une épaisseur inférieure à 0,1 mm, comportant au moins une étape dans laquelle la bande mince (1, 30) est soumise à des contraintes, **caractérisé par le fait que**, préalablement à l'étape du procédé dans laquelle la bande mince (1, 30) est soumise à des contraintes, on recouvre au moins une face de la bande mince par une couche de revêtement (3, 3', 31) comportant au moins une bande polymère constituée par un film plastique pré-encollé, auto-adhésif ou thermofusible, de manière à obtenir sur la bande mince métallique une couche adhérente d'une épaisseur comprise entre 1 et 100 µm, modifiant les propriétés de déformation et de rupture de la bande mince métallique et qu'on réalise l'étape du procédé dans laquelle la bande mince est soumise à des contraintes, sur la bande recouverte de la couche de revêtement.

2. Procédé suivant la revendication 1, **caractérisé par le fait que** la bande plastique pré-encollée auto-adhésive comporte une couche de substance auto-adhésive par pression et que la couche de revêtement auto-adhésive (3, 3') est rendue adhérente sur la bande mince métallique (1) par mise en pression de la couche de recouvrement (3, 3') sur la bande métallique mince (1).

3. Procédé suivant l'une quelconque des revendications 1 à 2, **caractérisé par le fait qu'**on met en contact une face de la bande métallique mince fragile (1) avec une première bande plastique préencollée auto-adhésive (3), la bande métallique mince fragile(1) devenant ainsi manipulable, qu'on met en contact la seconde face de la bande métallique mince fragile (1) avec une deuxième bande (3') plastique préencollée auto-adhésive, qu'on réalise une mise en pression de la bande stratifiée (6) constituée par la bande métallique mince fragile (1) entre les bandes plastiques préencollées auto adhésives (3, 3'), et qu'on réalise une opération mécanique par exemple de découpage sur la bande stratifiée (6).

4. Procédé suivant l'une quelconque des revendications 1 à 3, **caractérisé par le fait que** la bande plastique est constituée par l'un des matériaux suivants : polyester, polytétrafluoréthylène, polyimide.

5. Procédé suivant l'une quelconque des revendications 1 à 4, **caractérisé par le fait que** la substance adhésive par pression de la bande plastique pré-encollée auto-adhésive est une substance réticulable et qu'on réalise un traitement thermique de réticulation sur la couche de recouvrement adhérente sur la bande métallique mince.

6. Procédé suivant l'une quelconque des revendications 1 à 3, **caractérisé par le fait que** la bande plastique préencollée auto adhésive est en matériau polymère thermofusible tel que par exemple un des matériaux polymères suivants : polyéthylène modifié par l'acide acrylique ou l'anhydride maléique, polypropylène greffé, polyamide, et polyuréthanne.

7. Procédé selon l'une quelconque des revendications 1 à 6, **caractérisé par le fait que** la couche de revêtement comportant un matériau polymère présente une épaisseur comprise entre 1 et 50 µm.

8. Procédé suivant l'une quelconque des revendications 1 et 7, **caractérisé par le fait que** la bande mince en matériau nanocristallin présente une épaisseur de l'ordre de 20 µm.

9. Procédé suivant l'une quelconque des revendications 1 à 8, **caractérisé par le fait que** le matériau magnétique doux renferme du fer, du cuivre, du niobium, du silicium et du bore ou encore du fer, du zirconium, du bore et éventuellement du cuivre et du silicium.

10. Procédé suivant la revendication 9, **caractérisé par le fait que** la composition atomique de l'alliage magnétique doux est par exemple du type Fe-Cu-Nb-B-Si ou du type Fe-Zr-(Cu)-B-(Si) ou autre.

11. Procédé suivant l'une quelconque des revendications 1 à 10, **caractérisé par le fait que** l'étape dans laquelle la bande mince (1) est soumise à des contraintes est une opération de découpage mécanique.

12. Procédé suivant l'une quelconque des revendications 1 à 10, mettant en oeuvre une étape de découpage chimique d'une bande métallique mince (30) revêtue sur une de ses faces par une couche de revêtement en matériau polymère (31).

13. Procédé pour fabriquer une bande composite stratifiée comportant une pluralité de bandes métalliques minces fragiles **caractérisées en ce qu'**on prépare séparément une pluralité de bandes stratifiées (6) par le procédé selon l'une quelconque des revendications 1 à 5, dans lequel la bande plastique préencollée autoadhésive est une bande plastique préencollée double face, et on superpose et on relie par adhésion la pluralité de bandes stratifiées pour obtenir une bande composite stratifiée et on réalise une opération mécanique, par exemple de découpage, sur la bande de composite stratifiée.

14. Procédé pour fabriquer une bande composite stratifiée (11) comportant une pluralité de bandes métalliques minces fragiles **caractérisé en ce qu'**on prépare séparément une pluralité de bandes stratifiées (7a, 7b, 7c) par le procédé selon la revendication 6, chaque bande stratifiée comportant un film polymère sur chacune de ses faces, on chauffe la pluralité de bandes stratifiées (7a, 7b, 7c), on superpose et on comprime les unes contre les autres les bandes stratifiées de la pluralité de bandes stratifiées (7a, 7b, 7c) chauffées, pour obtenir une bande stratifiée composite (11) et on réalise sur la bande stratifiée (11) une opération mécanique telle qu'un découpage.

15. Procédé selon l'une quelconque des revendications 1 à 14 **caractérisé en ce que** le recouvrement de la bande mince par une bande polymère est effectué en continu.

16. Procédé suivant la revendication 1 pour la réalisation d'un composant (44) d'un circuit imprimé comportant au moins un enroulement (42, 43) tel qu'un transformateur (44), **caractérisé par le fait :**
- **qu'**on élabore une bande stratifiée (36) constituée d'une bande en alliage nanocristallin (36a) et d'un film de matière polymère (36b) adhérant sur une des faces de la bande en alliage nanocristallin,
- **qu'**on découpe la bande en alliage nanocristallin pour obtenir une pluralité de circuits magnétiques (37) en alliage nanocristallin adhérant chacun sur un tronçon du film de matière polymère (36b),
- **qu'**on découpe une pluralité de tronçons du film de matière polymère,
- **qu'**on empile la pluralité de tronçons de manière que les circuits magnétiques (37) soient exactement superposés et on réalise l'adhésion l'un sur l'autre des tronçons de film en matière polymère, pour obtenir un produit stratifié composite (40),
- **qu'**on perce les tronçons de films en matière polymère sur toute l'épaisseur du produit composite stratifié (40) pour réaliser des ouvertures traversantes (41) dans des zones situées à l'intérieur et dans des zones situées à l'extérieur des circuits magnétiques (37),
- **qu'**on métallise intérieurement les ouvertures traversantes (41), et
- **qu'**on réalise sur les deux faces du produit stratifié composite (40) des conducteurs électriques joignant les extrémités des ouvertures (41) sous la forme d'au moins un enroulement (42, 43).

17. Pièce magnétique comportant un alliage magnétique sous forme nanocristalline **caractérisée en ce qu'**elle comporte au moins une bande stratifiée constituée d'une bande mince métallique fragile en matériau magnétique sous forme nanocristalline collée sur au moins une bande polymère constituée par un film plastique pré-encollé, auto-adhésif ou thermofusible susceptible d'être obtenue par le procédé selon l'une quelconque des revendications 1 à 15.

18. Pièce magnétique suivant la revendication 17, **caractérisée par le fait qu'**elle constitue une pièce de transformateur plate (26a, 26b, 26c) ayant la forme d'un E, d'un I ou d'un U.

19. Pièce magnétique suivant la revendication 17, **caractérisée par le fait qu'**elle constitue un noyau magnétique torique (27a, 27b, 27c) en forme de rondelle ou en forme de cadre carré ou rectangulaire.

20. Pièce magnétique suivant la revendication 19, **caractérisée par le fait qu'**elle constitue un tore coupé (27c) présentant un entrefer de direction radiale (27'c).

21. Pièce magnétique suivant la revendication 17, **caractérisée par le fait qu'**elle constitue l'un des éléments suivants : pièce de circuit magnétique pour rotors ou stators de montres, rotor ou stator de moteur électrique, étiquette antivol, composant magnétique tel qu'inductance ou transformateur, en particulier inductance ou transformateur minces d'une épaisseur de l'ordre d'un millimètre.

22. Pièce magnétique suivant la revendication 17, **caractérisée par le fait qu'**elle constitue un transformateur (44) intégré à un circuit imprimé ou un transformateur discret.

23. Bande stratifiée constituée d'au moins une bande mince métallique fragile en alliage nanocristallin recouverte sur au moins une de ses faces par une bande adhérente polymère constituée d'un film plastique pré-encollé autoadhésif ou thermofusible.

## Patentansprüche

1. Verfahren zum Bearbeiten eines zerbrechlichen, dünnen metallischen Bandes (1, 30) aus einer weichmagnetischen Legierung mit nanokristalliner Struktur, die wenigstens 50 Vol-% feiner Kristalle mit einer Größe von weniger als 100 µm enthält, das durch Giessen des weichmagnetischen Werkstoffs in Form eines amorphen Bandes und durch Wärmebehandlung des amorphen Bandes, das eine Dicke von weniger als 0,1 mm besitzt, erhalten wird, wobei das Verfahren wenigstens einen Schritt umfasst, bei dem das dünne Band (1, 30) Beanspruchungen unterworfen wird, **dadurch gekennzeichnet, dass** vor dem Schritt des Verfahrens, bei dem das dünne Band (1, 30) Beanspruchungen unterworfen wird, wenigstens eine Fläche des dünnen Bandes mit einer Überzugschicht (3, 3', 31) bedeckt wird, die wenigstens ein Polymerband enthält, das durch eine im Voraus mit Klebstoff beschichtete, selbstklebende oder wärmeschmelzbare Kunststoffschicht gebildet ist, derart, dass auf dem dünnen metallischen Band eine Klebeschicht erhalten wird, deren Dicke im Bereich von 1 bis 100 µm liegt und die die Verformungs- und Brucheigenschaften des dünnen metallischen Bandes modifiziert, und dass der Schritt des Verfahrens, bei dem das dünne Band Beanspruchungen unterworfen wird, an dem mit der Überzugschicht bedeckten Band ausgeführt wird.

2. Verfahren nach Anspruch 1, **dadurch gekennzeichnet, dass** das im Voraus mit Klebstoff beschichtete, selbstklebende Kunststoffband eine Schicht aus einer mittels Druck selbstklebenden Substanz enthält und dass die selbstklebende Überzugschicht (3, 3') auf dem dünnen metallischen Band (1) durch Druckbeaufschlagung der Überzugschicht (3, 3') auf dem dünnen metallischen Band (1) klebend gemacht wird.

3. Verfahren nach einem der Ansprüche 1 bis 2, **dadurch gekennzeichnet, dass** eine Fläche des zerbrechlichen dünnen metallischen Bandes (1) mit einem ersten im Voraus mit Klebstoff beschichteten, selbstklebenden Kunststoffband (3) in Kontakt gebracht wird, wobei das zerbrechliche dünne metallische Band (1) dadurch handhabbar wird, dass die zweite Fläche des zerbrechlichen dünnen metallischen Bandes (1) mit einem zweiten im Voraus mit Klebstoff beschichteten, selbstklebenden Kunststoffband (3') in Kontakt gebracht wird, dass eine Druckbeaufschlagung des Schichtbandes (6), das aus dem zerbrechlichen dünnen metallischen Band (1) zwischen den im Voraus mit Klebstoff beschichteten, selbstklebenden Kunststoffbändern (3, 3') gebildet ist, ausgeführt wird und dass an dem Schichtband (6) ein mechanischer Vorgang, beispielsweise ein Schneidvorgang, ausgeführt wird.

4. Verfahren nach einem der Ansprüche 1 bis 3, **dadurch gekennzeichnet, dass** das Kunststoffband aus einem der folgenden Werkstoffe gebildet ist: Polyester, Polytetrafluorethylen, Polyimid.

5. Verfahren nach einem der Ansprüche 1 bis 4, **dadurch gekennzeichnet, dass** die mittels Druck klebende Substanz des im Voraus mit Klebstoff beschichteten, selbstklebenden Kunststoffbandes eine vemetzbare Substanz ist und dass eine thermische Vemetzungsbehandlung an der klebenden Überzugschicht auf dem dünnen Metallband ausgeführt wird.

6. Verfahren nach einem der Ansprüche 1 bis 3, **dadurch gekennzeichnet, dass** das im Voraus mit Klebstoff beschichtete, selbstklebende Kunststoffband aus einem wärmeschmelzbaren Polymerwerkstoff wie beispielsweise aus einem der folgenden Polymerwerkstoffe gebildet ist: Polyethylen, das durch Acrylsäure oder Maleinanhydrid modifiziert ist, veredeltes Polypropylen, Polyamid und Polyurethan.

7. Verfahren nach einem der vorhergehenden Ansprüche 1 bis 6, **dadurch gekennzeichnet, dass** die Überzugschicht, die einen Polymerwerkstoff enthält, eine Dicke im Bereich von 1 bis 50 µm aufweist.

8. Verfahren nach einem der Ansprüche 1 bis 7, **dadurch gekennzeichnet, dass** das dünne Band aus einem nanokristallinen Werkstoff eine Dicke in der Größenordnung 20 µm aufweist.

9. Verfahren nach einem der Ansprüche 1 bis 8, **dadurch gekennzeichnet, dass** der weichmagnetische Werkstoff Eisen, Kupfer, Niobium, Silicium und Bor oder aber Eisen, Zirkon, Bor und eventuell Kupfer und Silicium enthält.

10. Verfahren nach Anspruch 9, **dadurch gekennzeichnet, dass** die atomare Zusammensetzung der weichmagnetischen Legierung beispielsweise vom Typ Fe-Cu-Nb-B-Si oder vom Typ Fe-Zr-(Cu)-B-(Si) oder von einem anderen Typ ist.

11. Verfahren nach einem der Ansprüche 1 bis 10, **dadurch gekennzeichnet, dass** der Schritt, bei dem das dünne Band (1) Beanspruchungen unterworfen wird, ein mechanischer Schneidvorgang ist.

12. Verfahren nach einem der Ansprüche 1 bis 10, bei dem ein Schritt eines chemischen Schneidens eines dünnen metallischen Bandes (30), das auf einer seiner Flächen mit einer Überzugschicht (31) aus einem Polymerwerkstoff beschichtet ist, ausgeführt wird.

13. Verfahren zum Herstellen eines Schicht-Verbundbandes, das mehrere zerbrechliche dünne metallische Bänder aufweist, **dadurch gekennzeichnet, dass** getrennt mehrere Schichtbänder (6) durch das Verfahren nach einem der Ansprüche 1 bis 5 vorbereitet werden, wobei das im Voraus mit Klebstoff beschichtete, selbstklebende Kunststoffband ein im Voraus zweiseitig mit Klebstoff beschichtetes Kunststoffband ist, und dass die mehreren Schichtbänder übereinander gelegt und durch Kleben verbunden werden, um ein Schicht-Verbundband zu erhalten, und dass ein mechanischer Vorgang, beispielsweise ein Schneidvorgang, an dem Schicht-Verbundband ausgeführt wird.

14. Verfahren zum Herstellen eines Schicht-Verbundbandes (11), das mehrere zerbrechliche dünne metallische Bänder aufweist, **dadurch gekennzeichnet, dass** durch das Verfahren nach Anspruch 6 mehrere Schichtbänder (7a, 7b, 7c) getrennt vorbereitet werden, wobei jedes Schichtband auf jeder seiner Flächen eine Polymerschicht aufweist, dass die mehreren Schichtbänder (7a, 7b, 7c) erwärmt werden, dass die Schichtbänder der mehreren erwärmten Schichtbänder (7a, 7b, 7c) übereinander gelegt und aneinander gedrückt werden, um ein Verbund-Schichtband (11) zu erhalten, und dass an dem Schichtband (11) ein mechanischer Vorgang wie etwa ein Schneidvorgang ausgeführt wird.

15. Verfahren nach einem der Ansprüche 1 bis 14, **dadurch gekennzeichnet, dass** die Beschichtung des dünnen Bandes mit einem Polymerband ununterbrochen ausgeführt wird.

16. Verfahren nach Anspruch 1 für die Herstellung eines Bauelements (44) einer gedruckten Schaltung, die wenigstens eine Wicklung (42, 43) wie etwa einen Transformator (44) enthält, **dadurch gekennzeichnet,**
- **dass** ein Schichtband (36) hergestellt wird, das aus einem Band (36a) aus einer nanokristallinen Legierung und aus einer Schicht (36b) aus einem Polymerwerkstoff, die an einer der Flächen des Bandes aus einer nanokristallinen Legierung haftet, gebildet ist,
- **dass** das Band aus einer nanokristallinen Legierung zerschnitten wird, um mehrere Magnetkreise (37) aus einer nanokristallinen Legierung zu erhalten, die jeweils an einem Teilstück der Schicht (36b) aus einem Polymerwerkstoff haften,
- **dass** mehrere Teilstücke der Schicht aus einem Polymerwerkstoff abgeschnitten werden,
- **dass** die mehreren Teilstücke in der Weise gestapelt'werden, dass die Magnetkreise (37) genau übereinander liegen, und dass die Haftung der Teilstücke der Schicht aus einem Polymerwerkstoff aneinander bewirkt wird, um ein Verbund-Schichtprodukt (40) zu erhalten,
- **dass** die Teilstücke der Schichten aus Polymerwerkstoff über die gesamte Dicke des Schicht-Verbundprodukts (40) durchlocht werden, um Durchgangsöffnungen (41) sowohl in Zonen, die sich innerhalb der Magnetkreise (37) befinden, als auch in Zonen, die sich außerhalb der Magnetkreise (37) befinden, zu verwirklichen,
- **dass** die Durchgangsöffnungen (41) innen metallisiert werden und
- **dass** auf den zwei Flächen des Verbund-Schichtprodukts (40) elektrische Leiter verwirklicht werden, die die Enden der Öffnungen (41) in Form einer Wicklung (42, 43) verbinden.

17. Magnetisches Teil, das eine magnetische Legierung in nanokristalliner Form enthält, **dadurch gekennzeichnet, dass** es wenigstens ein Schichtband aufweist, das aus einem zerbrechlichen dünnen metallischen Band aus einem magnetischen Werkstoff in nanokristalliner Form, das an wenigstens ein Polymerband geklebt ist, das durch eine im Voraus mit Klebstoff beschichtete, selbstklebende oder wärmeschmelzbare Kunststoffschicht gegeben ist, gebildet ist, das durch das Verfahren nach einem der Ansprüche 1 bis 15 erhalten werden kann.

18. Magnetisches Teil nach Anspruch 17, **dadurch gekennzeichnet, dass** es ein flaches Transformatorteil (26a, 26b, 26c), das die Form eines E, eines I oder eines U hat, bildet.

19. Magnetisches Teil nach Anspruch 17, **dadurch gekennzeichnet, dass** es einen torischen Magnetkern (27a, 27b, 27c) in Form einer runden Scheibe oder in Form eines quadratischen oder rechtwinkligen Rahmens bildet.

20. Magnetisches Teil nach Anspruch 19, **dadurch gekennzeichnet, dass** es einen durchgeschnittenen Torus (27c) bildet, der einen Schlitz (27'c) in radialer Richtung aufweist.

21. Magnetisches Teil nach Anspruch 17, **dadurch gekennzeichnet, dass** es eines der folgenden Elemente bildet: Teil eines Magnetkreises für Rotoren oder Statoren von Uhren, Rotor oder Stator eines Elektromotors, Antidiebstahletikett, magnetisches Bauelement wie etwa Induktivität oder Transformator, insbesondere dünne Induktivität oder dünner Transformator mit einer Dicke in der Größenordnung eines Millimeters.

22. Magnetisches Teil nach Anspruch 17, **dadurch gekennzeichnet, dass** es einen in eine gedruckte Schaltung integrierten Transformator (44) oder einen diskreten Transformator bildet.

23. Schichtband, das aus wenigstens einem zerbrechlichen dünnen metallischen Band aus einer nanokristallinen Legierung gebildet ist, das auf wenigstens einer seiner Flächen mit einem Polymer-Klebeband bedeckt ist, das seinerseits durch eine im Voraus mit Klebstoff beschichtete, selbstklebende oder wärmeschmelzbare Kunststoffschicht gebildet ist.

## Claims

1. Treatment process for a thin fragile metal strip (1, 30) of low-retentivity alloy having a nanocrystalline structure, containing at least 50 % by volume of fine crystals having a size of less than 100 µm, obtained by casting the low-retentivity material in the form of an amorphous strip and heat treating the amorphous strip, having a thickness of less than 0.1 mm, involving at least one step in which the thin strip (1, 30) is subjected to stresses, **characterised in that**, before the step in which the thin strip (1, 30) is subjected to stresses, at least one side of the thin strip is covered'in a coating layer (3, 3', 31) comprising at least one polymer strip consisting of an adhesive-coated, self-adhesive or hot-melt plastic film, such that an adhesive layer in a thickness of between 1 and 100 µm is obtained on the thin metal strip, modifying the deformation and fracture characteristics of the thin metal strip, and that the process step in which the thin strip is subjected to stresses is performed on the strip covered in the coating layer.

2. Process according to claim 1, **characterised in that** the adhesive-coated self-adhesive plastic strip comprises a layer of a pressure-sensitive self-adhesive substance and that the self-adhesive coating layer (3, 3') is bonded to the thin metal strip (1) by pressing the coating layer (3, 3') onto the thin metal strip (1).

3. Process according to one of claims 1 to 2, **characterised in that** one side of the thin fragile metal strip (1) is placed in contact with a first adhesive-coated self-adhesive plastic strip (3), such that the thin fragile metal strip (1) is able to be manipulated, that the second side of the thin fragile metal strip (1) is placed in contact with a second adhesive-coated self-adhesive plastic strip (3'), that the laminated strip (6) formed by the thin fragile metal strip (1) between the adhesive-coated self-adhesive.plastic strips (3, 3') is subjected to pressure and that a mechanical cutting operation, for example, is performed on the laminated strip (6).

4. Process according to one of claims 1 to 3, **characterised in that** the plastic strip consists of one of the following materials: polyester, polytetrafluoroethylene, polyimide.

5. Process according to one of claims 1 to 4, **characterised in that** the pressure-sensitive adhesive substance on the adhesive-coated self-adhesive plastic strip is a crosslinkable substance and that a thermal crosslinking treatment is performed on the layer of adhesive coating on the thin metal strip.

6. Process according to one of claims 1 to 3, **characterised in that** the adhesive-coated self-adhesive plastic strip is made from a hot-melt polymeric material such as for example one of the following polymeric materials: polyethylene modified with acrylic acid or maleic anhydride, grafted polypropylene, polyamide and polyurethane.

7. Process according to one of claims 1 to 6, **characterised in that** the coating layer containing a polymeric material displays a thickness of between 1 and 50 µm.

8. Process according to one of claims 1 and 7, **characterised in that** the thin strip of nanocrystalline material has a thickness in the order of 20 µm.

9. Process according to one of claims 1 to 8, **characterised in that** the low-retentivity material contains iron, copper, niobium, silicon and boron or iron, zirconium, boron and optionally copper and silicon.

10. Process according to claim 9, **characterised in that** the atomic composition of the low-retentivity alloy is for example of the type Fe-Cu-Nb-B-Si or of the type Fe-Zr-(Cu)-B-(Si) or others.

11. Process according to one of claims 1 to 10, **characterised in that** the stage in which the thin strip (1) is subjected to stresses is a mechanical cutting operation.

12. Process according to one of claims 1 to 10, using a chemical cutting stage on a thin metal strip (30) covered on one side by a polymeric coating layer (31).

13. Process for the production of a laminated composite strip comprising multiple thin fragile metal strips, **characterised in that** multiple laminated strips (6) are prepared separately by the process according to one of claims 1 to 5, wherein the adhesive-coated self-adhesive plastic strip is a double-sided adhesive-coated plastic strip, and the multiple laminated strips are stacked and bonded to obtain a laminated composite strip, and a mechanical cutting operation, for example, is performed on the laminated composite strip.

14. Process for the production of a laminated composite strip (11) comprising multiple thin fragile metal strips, **characterised in that** multiple laminated strips (7a, 7b, 7c) are prepared separately by the process according to claim 6, each laminated strip including a polymer film on each side, the multiple laminated strips (7a, 7b, 7c) are heated, the laminated strips from the multiple heated laminated strips (7a, 7b, 7c) are stacked and compressed against one another to obtain a composite laminated strip (11) and a mechanical operation such as cutting is performed on the laminated strip (11).

15. Process according to one of claims 1 to 14, **characterised in that** the thin strip is covered by a polymer strip in a continuous process.

16. Process according to claim 1 for the production of a component (44) of a printed circuit board comprising at least one winding (42, 43), such as a transformer (44), **characterised in that**:
- a laminated strip (36) consisting of a strip of nanocrystalline alloy (36a) and a film of polymeric material (36b) adhering to one side of the nanocrystalline alloy strip is produced,
- the nanocrystalline alloy strip is cut to obtain multiple magnetic circuits (37) made from nanocrystalline alloy, each adhering to a section of the polymer film (36b),
- multiple sections of the polymer film are cut out,
- the multiple sections are stacked such that the magnetic circuits (37) are stacked precisely on top of one another and the sections of polymer film are bonded to one another to obtain a composite laminated product (40),
- the sections of polymer film are pierced through the entire thickness of the laminated composite product (40) to produce through-hole apertures (41) in zones located on the inside and zones located on the outside of the magnetic circuits (37),
- the through-hole apertures (41) are metallised on the inside, and
- electrical conductors joining the ends of the apertures (41) are produced on both sides of the composite laminated product (40) in the form of at least one winding (42, 43).

17. Magnetic part consisting of a magnetic alloy in nanocrystalline form, **characterised in that** it comprises at least one laminated strip consisting of a thin fragile metal strip of magnetic material in nanocrystalline form bonded to at least one polymer strip consisting of an adhesive-coated, self-adhesive or hot-melt plastic film capable of being obtained by the process according to one of claims 1 to 15.

18. Magnetic part according to claim 17, **characterised in that** it constitutes a flat transformer part (26a, 26b, 26c) in the shape of an E, I or U.

19. Magnetic part according to claim 17, **characterised in that** it constitutes a magnetic toroidal core (27a, 27b, 27c) in the form of a ring or in the form of a square or rectangular frame.

20. Magnetic part according to claim 19, **characterised in that** it constitutes an open toroidal core (27c) displaying a radial gap (27'c).

21. Magnetic part according to claim 17, **characterised in that** it constitutes one of the following elements: magnetic circuit part for rotors or stators for watches, rotor or stator for an electric motor, anti-theft label, magnetic component such as an inductive resistor or transformer, in particular a thin inductive resistor or transformer having a thickness in the order of one millimetre.

22. Magnetic part according to claim 17, **characterised in that** it constitutes a transformer (44) built into a printed circuit board or a self-contained transformer.

23. Laminated strip consisting of at least one thin fragile metal strip of nanocrystalline alloy covered on at least one side by an adhesive polymer strip consisting of an adhesive-coated self-adhesive or hot-melt plastic film.
